# EUROPEAN PATENT APPLICATION

(11) **EP 4 814 504 A1**
(43) Date of publication of application: **30.09.2026**
(21) Application number: 26157569.0
(22) Date of filing: 10.02.2026
(51) Int. Cl.: G01R 31/00, H04B 17/00

(54) **MEASUREMENT APPLICATION DEVICE, MEASUREMENT APPLICATION SYSTEM, AND METHOD**

(30) Priority: 10.03.2025 US 202519075552
(71) Applicant: Rohde & Schwarz GmbH & Co. KG, 81671 München (DE)
(72) Inventor: OHLEN, Volker, 85652 Pliening (DE); HERBORDT, Wolfgang, 85521 Ottobrunn (DE); KUHWALD, Thomas, 85570 Markt Schwaben (DE); SCHULZE, Guido, 85567 Grafing b. München (DE); SAALFELD, Maximilian, 80993 München (DE)
(74) Representative: Kehl, Ascherl, Liebhoff & Ettmayr Patentanwälte Partnerschaft mbB

(57) **Abstract**

The present disclosure provides a measurement application device for analyzing a device under test comprising at least two measurement inputs, wherein one of the measurement inputs is configured to acquire a test signal provided to the device under test by a signal generation device, and one of the measurement inputs is configured to acquire an output signal that is generated by the device under test in response to the test signal, and a signal analyzer that is coupled to the at least two measurement inputs and that is configured to determine at least a bit error rate for the device under test based on the test signal and the output signal prior to storing at least one of the test signal and the output signal in the measurement application device. The present disclosure further provides a respective measurement application system, and a respective method.

## Description

### TECHNICAL FIELD

The disclosure relates to a measurement application device, a respective measurement application system, and a respective method.

### BACKGROUND

Although applicable to any type of communication system, the present disclosure will mainly be described in conjunction with communication systems that use PAM-N signals for data transmission.

During the development of modern communication systems it may be required to test the signal quality provided by the respective communication system and it's components.

Accordingly, there is a need for providing efficient testing of the signal quality in such communication systems.

### SUMMARY

The above stated problem is solved by the features of the independent claims. It is understood, that independent claims of a claim category may be formed in analogy to the dependent claims of another claim category.

Accordingly, it is provided:
A measurement application device for analyzing a device under test comprising at least two measurement inputs, wherein one of the measurement inputs is configured to acquire a test signal provided to the device under test by a signal generation device, and one of the measurement inputs is configured to acquire an output signal that is generated by the device under test in response to the test signal, and a signal analyzer that is coupled to the at least two measurement inputs and that is configured to determine at least a bit error rate for the device under test based on the test signal and the output signal prior to or in parallel to storing at least one of the test signal and the output signal in the measurement application device.

Further, it is provided:
A measurement application device for analyzing a device under test, the measurement application device comprising at least one measurement input, wherein the at least one measurement input is configured to acquire an output signal that is generated by the device under test in response to a test signal that is provided to the device under test, and a signal analyzer that is coupled to the at least one measurement input, wherein the signal analyzer comprises a signal decoder that is configured to decode the received output signal and synchronize the signal analyzer on the output signal based on a known signal type of the output signal, and wherein the signal analyzer further comprises a sequence generator that is configured to generate a predefined PN-sequence after synchronization of the signal analyzer with the output signal, and wherein the signal analyzer is configured to determine at least a bit error rate for the device under test based on the output signal and the generated PN-sequence.

Further, it is provided:
A measurement application system for analyzing a device under test comprising a signal generation device configured to output a test signal to a device under test, and a measurement application device comprising at least two measurement inputs, wherein one of the measurement inputs is configured to acquire the test signal provided to the device under test, and one of the measurement inputs is configured to acquire an output signal that is generated by the device under test in response to the test signal, wherein the measurement application device further comprises a signal analyzer that is coupled to the at least two measurement inputs and that is configured to determine at least a bit error rate for the device under test based on the test signal and the output signal prior to or in parallel to storing at least one of the test signal and the output signal in the measurement application device.

Further, it is provided:
A measurement method for analyzing a device under test, the method comprising outputting a test signal to a device under test from a signal generation device, acquiring the test signal provided to the device under test with a measurement application device, acquiring an output signal that is generated by the device under test in response to the test signal with a measurement application device, and determining at least a bit error rate for the device under test with a signal analyzer in the measurement application device based on the acquired test signal and the acquired output signal prior to or in parallel to storing at least one of the test signal and the output signal in the measurement application device.

The present disclosure is based on the finding that testing modern communication systems may be a difficult task. For example, modern communication systems may employ PAM-N signals with N constellation symbols. In such communication systems bit errors may occur depending on the signal quality in respective signal paths of the communication system.

During development and testing of components for such communication systems, the bit error rate, also called BER, may be determined with conventional bit error rate testers, also called BERT for single components of the communication systems. However, the software based approach of such BERTs limits the minimum BER that can be measured, since only a limited amount of memory is available in the BERT. Further, it is not possible to perform protocol related communication tests, since the latency with such BERTs is too high.

The present disclosure consequently proposes a measurement application device, and a respective system that allow determining e.g., the BER for a device under test for an unlimited amount of time and in real time.

To this end, the measurement application system comprises a signal generation device, and a measurement application device. For performing a BER measurement, the signal generation device generates and outputs a test signal to a device under test, also called DUT herein. The DUT will then process the test signal and output a respective output signal. It is understood, that the measurement application system may comprise any one of the measurement application devices disclosed herein, like a measurement application device that actively acquires the test signal and the output signal, or a measurement application device that determines a PN-sequence based on the measured output signal and only acquires the output signal.

The measurement application device comprises at least two measurement inputs, one for the test signal, and one for the output signal, and a signal analyzer that is coupled to the measurement inputs and analyzes the test signal, and the output signal before they are stored in a memory, like an acquisition memory, of the measurement application device.

It is understood, that the measurement application system may be combined or with or use any of the embodiments of the measurement application device disclosed herein.

The signal analyzer, therefore, continuously analyzes the test signal, and the output signal, and calculates e.g., the BER, for the output signal provided by the DUT. To this end, the signal analyzer may comprise e.g., an ASIC, CPLD, or FPGA, or any other processing element that is capable of performing the respective computations. Such computations may comprise determining the value of the respective sample, and comparing the value to the respective expected value in order to determine a bit error.

The signal analyzer may be coupled to the signal paths between the measurement inputs and the further signal processing sections of the measurement application device, and extract the relevant signals for performing the signal analysis. It is understood, that each one of the elements disclosed herein as part of the measurement application device, or the signal generation device, may be provided with respective signal ports, or other circuitry required to interface the respective element with other elements.

The test signal may in embodiments comprise a PAM-N signal, like a PAM-4 signal. However, this is just an example, and the test signal is not limited to such signal types. Instead, any signal type that is adequate for use with the respective DUT may be used as a test signal. In embodiments, the test signal may also be based on a pseudo-random noise signal or a pseudo-random sequence, also called PN-sequence. A PN-sequence is a periodic signal that only seems to be a random signal. PN-sequences are often used when performing tests, like measuring the BER of a DUT.

It is understood, that the measurement application device may comprise a display, especially with the measurement application device being implemented as or in an oscilloscope. The measurement application device may in such embodiments display at least one of a protocol status of the data protocol used by the test signal and the output signal, a link status, and an eye diagram.

With the solution according to the present disclosure, it is possible to continuously analyze and e.g., calculate the BER, for a DUT. It is, consequently, possible to test very low BER thresholds and monitor devices for a long period of time. By analyzing the test signal and the output signal before these signals are stored, a signal analysis in real-time is possible for high speed data signals. The data rate of such signals may be higher than 150 Gs/s (gigasamples per second).

This is not possible with traditional BERTs, since the BER determination is performed in software after the signal to be analyzed is stored in an acquisition memory of the respective BERT. However, such an acquisition memory only provides a limited storage capacity that does not allow determining very low BER values.

The measurement application device according to the present disclosure may generally implement any type of device that may be used in a measurement application or measurement application system. Such a measurement application device may comprise any device that may be used in a measurement application to acquire an input signal or to generate an output signal, or to perform additional or supporting functions in a measurement application. A measurement application device may also comprise or be implemented as program application or program applications, also called measurement program application or measurement program applications, that may be executed on a computer device and that may communicate with other measurement application devices in order to perform a measurement task. A measurement application or measurement application system, also called measurement setup, may e.g., comprise at least one or multiple different measurement application devices for performing electric, magnetic, or electromagnetic measurements, especially on single devices under test. A measurement application device according to the present disclosure may be configured to perform such electric, magnetic, or electromagnetic measurements e.g., in a measurement laboratory or in a production facility in the respective production line on a device under test, DUT. An exemplary measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test, or at least one signal generation section for generating electric, magnetic, or electromagnetic signals that may be provided to the device under test. Such a signal acquisition section may comprise, but is not limited to, a front-end for acquiring, filtering, and attenuating or amplifying electrical signals. The signal generation section may comprise, but is not limited to, respective signal generators, amplifiers, and filters. In embodiments, the signal acquisition is performed via the signal acquisition section in a wired or contact-based manner or fashion. To this end, a respective measurement probe may be coupled to the measurement application device via a respective cable. In embodiments, the signal generation and emission is performed via the signal generation section in a wired or contact-based manner or fashion. To this end, a respective signal output probe may be coupled to the measurement application device via a respective cable, or the signal may be output directly via the cable e.g., to a device under test. In further embodiments, the signal acquisition is performed via the signal acquisition section in a wireless or contact-lass manner or fashion, e.g. via respective antennas, also called over-the-air or OTA. In further embodiments, the signal generation and emission is is performed in a wireless or contact-lass manner or fashion, e.g. via respective antennas, also called over-the-air or OTA. A combination of contact-based signal acquisition, contact-less signal acquisition, contact-based signal generation and emission is, and contact-less signal generation and emission is is possible.

Further, when acquiring signals, measurement application devices may comprise a signal processing section that may process the acquired signals. Processing may comprise converting the acquired signals from analog-to-digital signals or vice versa, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a spectrum analyzer, or a vector network analyzer. Such a measurement device may also comprise a signal generation device e.g., a signal generator, especially an arbitrary signal generator, also called arbitrary waveform generator, a vector signal generator, or a mobile radio communication tester. Further possible measurement application devices comprise devices like calibration standards, or measurement probe tips.

Of course, at least some of the possible functions, like signal acquisition and signal generation, may be combined in a single measurement application device.

In embodiments, the measurement application device may comprise pure data acquisition devices that are capable of acquiring an input signal and of providing the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

In embodiments, the measurement application system may comprise an adapter that is provided between the DUT and at least one of the signal generation device and the measurement application device. Such an adapter may serve to at least one of mechanically and electrically adapt, e.g., the impedance of the signal path, or the signal levels in the signal path. The adapter may also comprise other fixtures for performing any type of channel simulation. Such channel simulation components may also be provided in the signal generation device or in the measurement application device.

In embodiments, the measurement application device may comprise the signal generation device in any one of the embodiments disclosed herein. Integration of the signal generation device into the measurement application device provides for a compact and easy to transport measurement application system.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to independent claim 1 can be combined in all variations with each other and the disclosure of the description is not limited to the claim dependencies as specified in the claim set. Further, the features of the dependent claims referring to independent claim 1 may be combined with any of the features of the other independent claims or the dependent claims relating to any one of the other independent claims. In a respective method, respective method steps may perform the function of the respective apparatus elements, and in a respective apparatus, respective apparatus elements may perform the respective method steps.

In an embodiment, which can be combined with all other embodiments mentioned above or below, the measurement application device may further comprise an analog-to-digital converter for each one of the measurement inputs that is coupled to the respective measurement input, an acquisition memory, and a signal acquisition path arranged between the analog-to-digital converters, and the acquisition memory, wherein the signal analyzer is arranged in the signal acquisition path, and wherein the signal analyzer is coupled to the analog-to-digital converters.

As explained above, the measurement application device, more specifically, the signal analyzer in the measurement application device, analyzes the output signal prior to storing the signal in a memory of the measurement application device.

With the above provided set-up, the measurement application device comprises an analog-to-digital converter for each one of the measurement inputs, and an acquisition memory that is coupled to the analog-to-digital converters for short term storage of measured signals. In digital real-time oscilloscopes the triggering may e.g., be performed based on the data stored in the acquisition memory.

According to the present disclosure, the signal analyzer is coupled to the analog-to-digital converters, and is therefore not arranged after the acquisition memory, but in parallel to the acquisition memory. The signal analyzer may consequently operate directly on the digital data as it is provided by the analog-to-digital converters, and not on the stored data only.

This means, that the signal analyzer may operate on a continuous stream of digital data samples, and therefore, on signals of any length without limitations and without interruptions. In the context of the present disclosure, the signal analyzer may, therefore, be referred to as a real-time signal analyzer or as analyzing the signals in real-time. "Real-time" in this regard may refer to the signal analyzer processing every digital data sample provided by the analog-to-digital converters with the same sample rate as provided by the analog-to-digital converters.

In a further embodiment, which can be combined with all other embodiments mentioned above or below, the signal analyzer may comprise a signal decoder that is configured to decode the received output signal and synchronize the signal analyzer on the output signal based on a known signal type of the output signal.

The signal decoder may be embodied within the same ASIC, CPLD, FPGA or processor as the signal analyzer, or as a dedicated element coupled to the signal analyzer.

Usually, in PAM-N signals, no dedicated clock is provided, but the receiver synchronizes onto the received signal by applying some kind of clock data recovery. In the signal analyzer, the signal decoder may perform this clock data recovery, and may, therefore, synchronize onto the output signal as any other receiver would. The signal decoder may comprise e.g., a clock data recovery module that determines the clock of the output signal. Based on the determined clock, the symbol width may be determined. The correct sample time may then be determined as the center of a symbol, and the decision of the sample value may be taken based on the sample value at the respective symbol center.

An error detector may also be provided that compares the sample value determined from the output signal with the sample value indicated by the test signal, and identifies an error if the values differ.

In the signal analyzer, it is easy to detect an incorrect synchronization. In case that the signal analyzer is not correctly synchronized to the output signal, the BER will always be 0.5. A respective comparator in the signal analyzer may in such cases trigger a re-synchronization in the signal decoder. In embodiments, a synchronization indication may be provided to a user after successful synchronization.

In another embodiment, which can be combined with all other embodiments mentioned above or below, the signal analyzer may further comprise a sequence generator that is configured to generate a predefined PN-sequence after synchronization of the signal analyzer with the output signal, wherein the bit error rate may be determined based on the output signal and the generated PN-sequence.

The sequence generator may comprise an active element that generates the required PN-sequence. As alternative, the sequence generator may comprise a memory that has the PN-sequence stored thereon any may be read by the signal analyzer.

As explained above, PN-sequences may be used to form the test signal. Such PN-sequences are periodic signals, and thus, comprise a sequence that is continuously repeated.

In the measurement application system, a predetermined known PN-sequence may be used for generating the test signal. Consequently, with a known PN-sequence as basis for the test signal, the signal analyzer may recreate this known PN-sequence internally and synchronize the internally generated PN-sequence with the output signal.

The determination of the BER may in this case be based on the internally generated PN-sequence, and the output signal only. The test signal in such embodiments not necessarily needs to be provided to the measurement application device.

It is understood, that any other function described herein as being performed based on the test signal and the output signal, may also be performed based on the output signal, and the internally generated PN-sequence.

In another further embodiment, which can be combined with all other embodiments mentioned above or below, the signal analyzer may further be configured to identify at least a single erroneous bit transition of the device under test based on the test signal and the output signal, and output a respective user information.

In contrast to known BERTs, with the measurement application device it is possible to analyze the output signal continuously and in real-time, as explained above.

Consequently, a respective output signal may directly be generated and provided to a user as soon as a single erroneous bit transition is detected in the output signal.

In an embodiment, which can be combined with all other embodiments mentioned above or below, the signal analyzer may further be configured to output at least one of a determined overall bit error rate, an instantaneous bit error rate, a bit error rate for a specific time frame, and an erroneous bit transition of at least one of the test signal and the output signal.

Instead of only determining a general BER, other types of BER may also be determined.

A BER may, for example, be determined for a specific time frame, or an instantaneous BER may be determined.

In another embodiment, which can be combined with all other embodiments mentioned above or below, the measurement application device may further comprise a digital data interface that is coupled to a digital data interface of the signal generation device, wherein the measurement application device may be configured to receive information regarding the test signal from the signal generation device via the digital data interface.

The information regarding the test signal may comprise information required to synchronize the signal analyzer to the test signal, and therefore, the output signal. The information regarding the test signal may be a simple digital clock signal. The measurement application device may, therefore, synchronize on the test signal based on the information received via the digital data interface.

In embodiments, different or further information regarding the test signal may be provided, e.g., the type of the test signal or the whole waveform of the test signal. The information may also comprise control data or parameters regarding the test signal.

With this embodiment, the measurement application device does not need to include any logic to directly synchronize on the received output signal.

Further, in embodiments, the measurement application device may output digital data to the signal generation device, e.g., control data to start or stop the signal generation device via the digital data interface.

In another embodiment, which can be combined with all other embodiments mentioned above or below, the measurement inputs that are configured to acquire a test signal may comprise the digital data interface. In such embodiments the test signal is not acquired as an analog waveform. Instead, a digital signal representing the testsignal or comprising information regarding the test signal may be provided via the digital data interface.

In another embodiment, which can be combined with all other embodiments mentioned above or below, the measurement application device may further be configured to communicate with the device under test.

The measurement application device may communicate with the DUT for performing any type of communication, like an inband communication. The measurement application device may communicate with the DUT, e.g., in order to bring the DUT into a state that allows performing respective measurements. The measurement application device may e.g., perform any communication establishment communication that may be required in order for a DUT to start processing of the test signal. Such a communication may comprise, e.g., a PCI Link Initialization.

In other embodiments, the signal generation device may perform such communication in addition or as alternative to the measurement application device.

In another embodiment, which can be combined with all other embodiments mentioned above or below, the measurement application system may further comprise a first signal path configured to transport the test signal from the signal generation device to the device under test, a second signal path configured to transport the output signal from the device under test to the measurement application device, and a third signal path configured to transport the test signal from the signal generation device to the measurement application device. As alternative, the measurement application system may comprise a first signal path configured to transport the test signal from the signal generation device to the device under test and the measurement application device, and a second signal path configured to transport the output signal from the device under test to the measurement application device.

The measurement application system may comprise different architectures.

In a first possible architecture, dedicated signal paths are provided between the signal generation device, the DUT and the measurement application device. The first signal path couples the signal generation device with the DUT, the second signal path couples the DUT with the measurement application device, and the third signal path couples the signal generation device with the measurement application device.

In another architecture, a first signal path couples the signal generation device with the DUT and the measurement application device, and a second signal path couples the DUT with the measurement application device. Other architectures are possible.

In an embodiment of the measurement application system, which can be combined with all other embodiments mentioned above or below, the signal generation device may further comprise a digital data interface, and the measurement application device may further comprise a digital data interface that is coupled to the digital data interface of the signal generation device, wherein the signal generation device may be configured to output information regarding the test signal to the measurement application device via the digital data interface.

The explanations regarding the digital data interface provided above for the measurement application device apply mutatis mutandis to the digital data interface of the signal generation device.

In a further embodiment, which can be combined with all other embodiments mentioned above or below, the signal generation device and the measurement application device may further be configured to communicate with the device under test.

The explanations regarding the communication with the DUT provided above for the measurement application device apply mutatis mutandis to the signal generation device.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a measurement application device according to the present disclosure;
Figure 2 shows a block diagram of another embodiment of a measurement application device according to the present disclosure;
Figure 3 shows a block diagram of a further embodiment of a measurement application device according to the present disclosure;
Figure 4 shows a block diagram of another embodiment of a measurement application device according to the present disclosure;
Figure 5 shows a block diagram of an embodiment of a measurement application system according to the present disclosure;
Figure 6 shows a block diagram of an oscilloscope that may implement an embodiment of a measurement application device according to the present disclosure;
Figure 7 shows a block diagram of another oscilloscope that may implement an embodiment of a measurement application device according to the present disclosure; and
Figure 8 shows a flow diagram of an embodiment of a method according to the present disclosure.

In the figures like reference signs denote like elements unless stated otherwise.

### DETAILED DESCRIPTION OF THE DRAWINGS

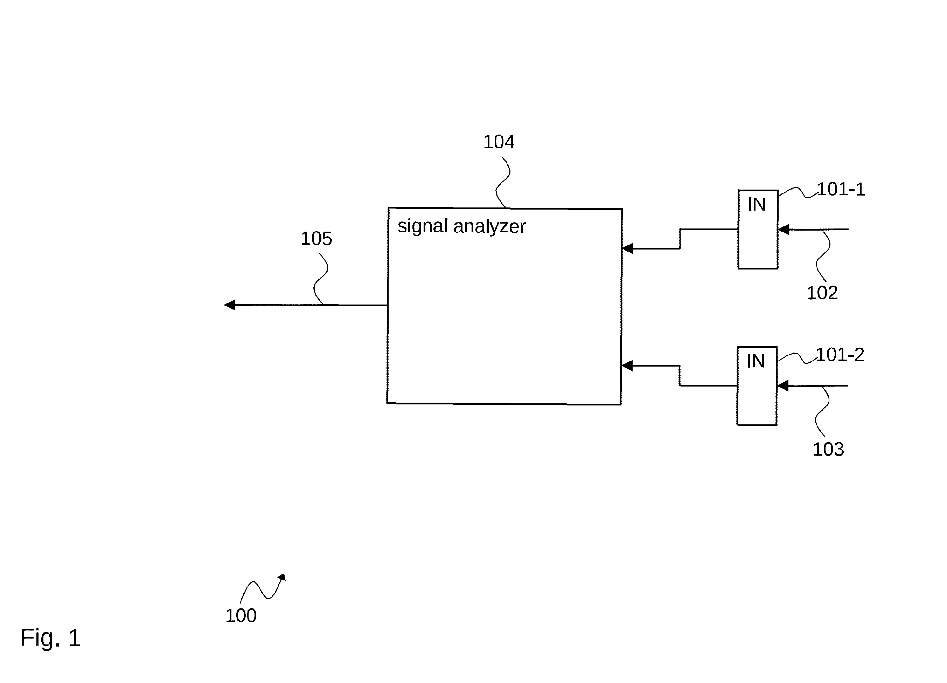

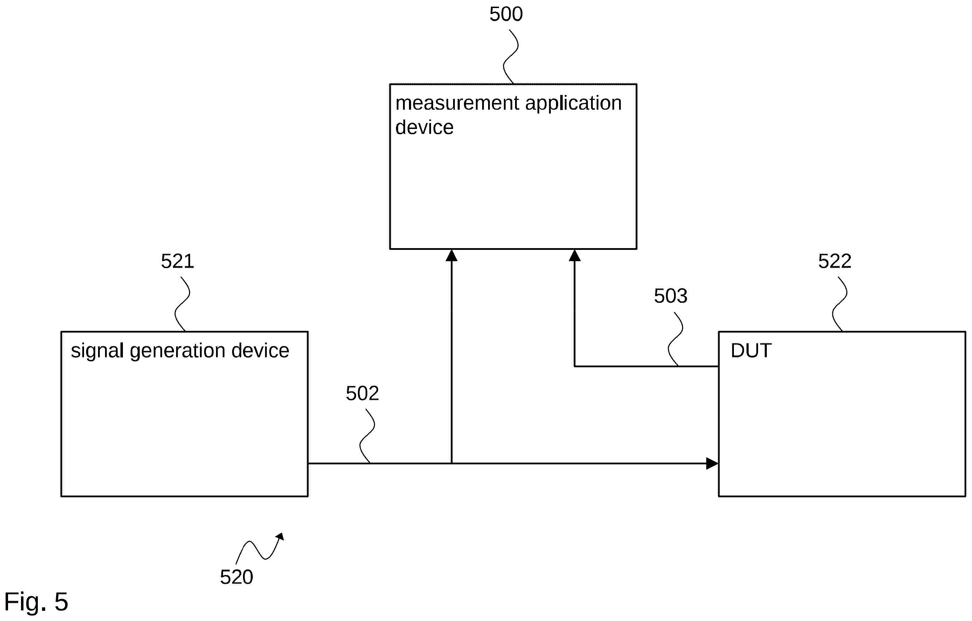

Figure 1 shows a block diagram a measurement application device 100. The measurement application device 100 comprises two measurement inputs 101-1, 101-2 that are coupled to a signal analyzer 104. One measurement input 101-1 receives a test signal 102, and the other measurement input 101-2 receives an output signal 103. The test signal 102 is a signal generated by a signal generation device (see e.g., figure 5), and the output signal 103 is a signal generated by a DUT (see e.g., figure 5) based on the test signal 102. The signal analyzer 104 determines a bit error rate 105 for the device under test based on the test signal 102 and the output signal 103. The signal analyzer 104, although not explicitly shown, analyzes the test signal 102, and the output signal 103 prior to or in parallel to the process of storing at least one of the test signal and the output signal in the measurement application device 100. The explanations provided herein for any embodiment of the measurement application device also apply to the measurement application device 100.

The signal analyzer 104 may be further configured to identify at least a single erroneous bit transition of the device under test as the bit error rate 105 based on the test signal 102 and the output signal 103, and output a respective user information. Instead or in addition to the single erroneous bit transition, the signal analyzer 104 may detect and output respective information for at least one of a determined overall bit error rate, an instantaneous bit error rate, and a bit error rate for a specific time frame.

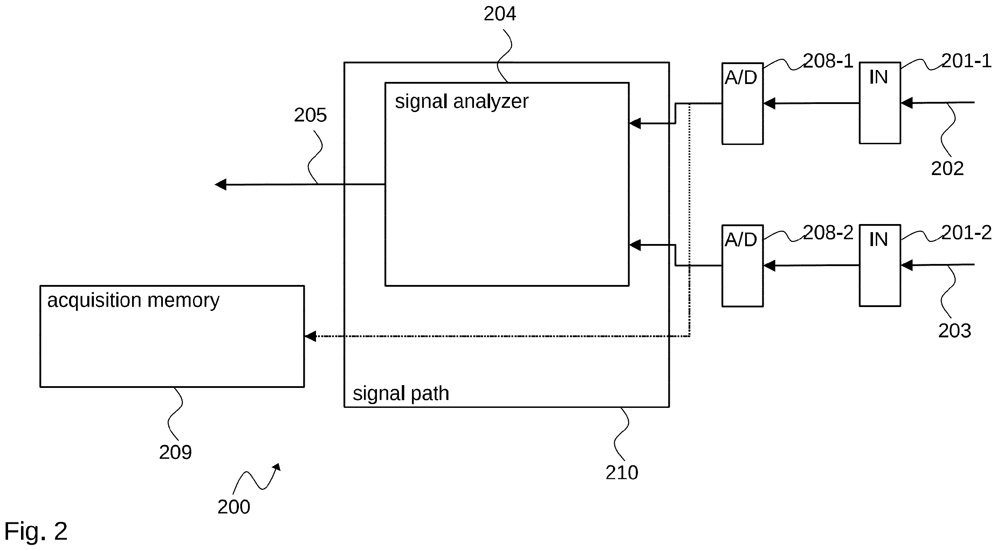

Figure 2 shows a block diagram a measurement application device 200. The measurement application device 200 is based on measurement application device 100. Therefore, the measurement application device 200 comprises two measurement inputs 201-1, 201-2 that are coupled to a signal analyzer 204. One measurement input 201-1 receives a test signal 202, and the other measurement input 201-2 receives an output signal 203. The test signal 202 is a signal generated by a signal generation device (see e.g., figure 5), and the output signal 203 is a signal generated by a DUT (see e.g., figure 5) based on the test signal 202. The signal analyzer 204 determines a bit error rate 205 for the device under test based on the test signal 202 and the output signal 203. The signal analyzer 204, although not explicitly shown, analyzes the test signal 202, and the output signal 203 prior to or in parallel to the process of storing at least one of the test signal and the output signal in the measurement application device 200. The explanations provided herein for any embodiment of the measurement application device also apply to the measurement application device 200.

The measurement application device 200 further comprises an internal signal path 210, wherein the signal analyzer 204 is arranged in the internal signal path 210. The term internal signal path 210 not necessarily requires a hardware element, but may be seen as container of logical group of elements or signal lines. Further, the measurement application device 200 comprises an analog-to-digital converter 208-1 that is coupled between the measurement input 201-1, and the signal path 210, and an analog-to-digital converter 208-2 that is coupled between the measurement input 201-2, and the signal path 210. The output signals from analog-to-digital converter 208-1, and analog-to-digital converter 208-2 are both provided directly to signal analyzer 204, and in parallel are provided through the signal path 210 to an acquisition memory 209. The acquisition memory 209 serves for short term storage of the acquired test signal 202, and output signal 203 and further processing of these signals in the measurement application device 200.

In the measurement application device 200 it can be seen that the signal analyzer 204 operates independently or in parallel to the further signal processing of the acquired signals in the measurement signal path of the measurement application device 200, also called measurement frontend or frontend. Of course, the output from the signal analyzer 204, e.g., the bit error rate 205 may also be stored in the acquisition memory 209 or may be provided to any other element of the measurement application device 200.

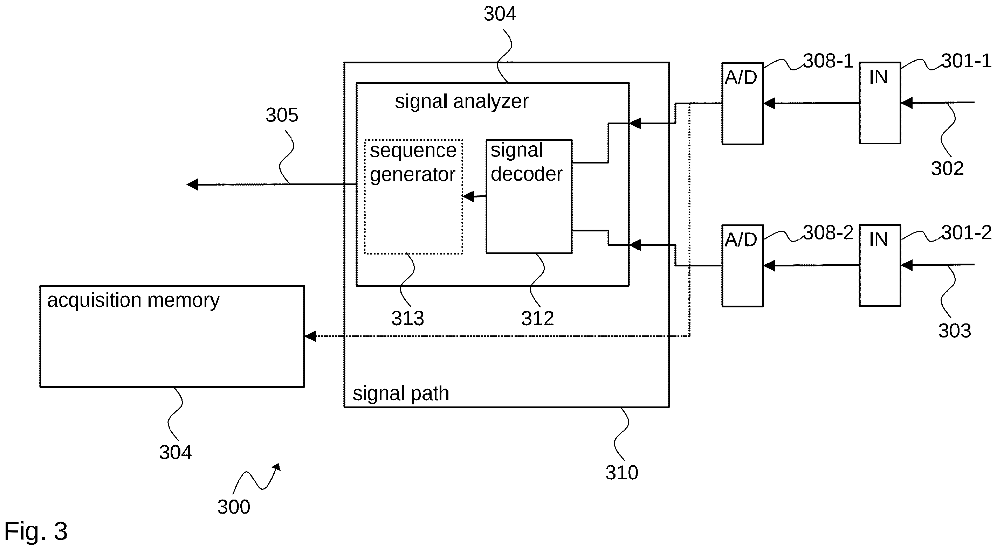

Figure 3 shows a block diagram a measurement application device 300. The measurement application device 300 is based on measurement application device 200. Therefore, the measurement application device 300 comprises two measurement inputs 301-1, 301-2 that are coupled to a signal analyzer 304. One measurement input 301-1 receives a test signal 302, and the other measurement input 301-2 receives an output signal 303. The test signal 302 is a signal generated by a signal generation device (see e.g., figure 5), and the output signal 303 is a signal generated by a DUT (see e.g., figure 5) based on the test signal 302. The signal analyzer 304 determines a bit error rate 305 for the device under test based on the test signal 302 and the output signal 303. The signal analyzer 304, although not explicitly shown, analyzes the test signal 302, and the output signal 303 prior to or in parallel to the process of storing at least one of the test signal and the output signal in the measurement application device 300. The measurement application device 300 further comprises an internal signal path 310, wherein the signal analyzer 304 is arrange in the internal signal path 310. Further, the measurement application device 300 comprises an analog-to-digital converter 308-1 that is coupled between the measurement input 301-1, and the signal path 310, and an analog-to-digital converter 308-2 that is coupled between the measurement input 301-2, and the signal path 310. The output signals from analog-to-digital converter 308-1, and analog-to-digital converter 308-2 are both provided directly to signal analyzer 304, and in parallel are provided through the signal path 310 to an acquisition memory 309. The explanations provided herein for any embodiment of the measurement application device also apply to the measurement application device 300.

In embodiments, the measurement application device 300 may comprise only one measurement input that is coupled to the signal analyzer 304 and that receives the output signal 303.

In the measurement application device 300, the signal analyzer 304 comprises a signal decoder 312 that may decode the received output signal 303 and synchronize the signal analyzer on the output signal 303 based on a known signal type of the output signal 303. The known signal type may comprise, e.g., a PAM-N signal.

Further, the signal analyzer 304 comprises an optional sequence generator 313. The sequence generator 313 may be provided to generate a predefined PN-sequence after synchronization of the signal analyzer 304 with the output signal 303. The bit error rate 305 may in this embodiment be determined based on the output signal 303 and the generated PN-sequence.

The sequence generator 313 may be used as an alternative to the test signal 302. For example, the test signal 302 may be generated based on the same PN-sequence by the signal generation device, and will, therefore, comprise a repeating sequence that will be continuously replayed. After synchronizing to the output signal 303 with the signal decoder 312, instead of using the test signal 302 for detecting bit errors in the output signal 303, the internally generated PN-sequence may be used. In such embodiments, it is not required to receive or acquire the test signal 302.

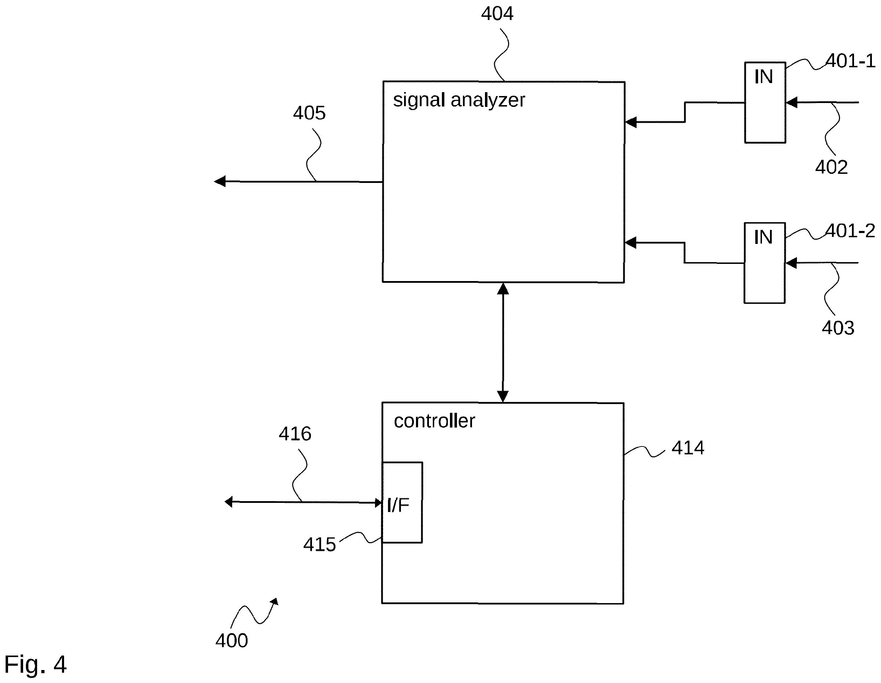

Figure 4 shows a block diagram a measurement application device 400. The measurement application device 400 is based on measurement application device 100. Therefore, the measurement application device 400 comprises two measurement inputs 401-1, 401-2 that are coupled to a signal analyzer 404. One measurement input 401-1 receives a test signal 402, and the other measurement input 401-2 receives an output signal 403. The test signal 402 is a signal generated by a signal generation device (see e.g., figure 5), and the output signal 403 is a signal generated by a DUT (see e.g., figure 5) based on the test signal 402. The signal analyzer 404 determines a bit error rate 405 for the device under test based on the test signal 402 and the output signal 403. The signal analyzer 404, although not explicitly shown, analyzes the test signal 402, and the output signal 403 prior to or in parallel to the process of storing at least one of the test signal and the output signal in the measurement application device 400. The explanations provided herein for any embodiment of the measurement application device also apply to the measurement application device 400.

The measurement application device 400 further comprises a digital data interface 415, which is exemplarily comprised in a controller 414. The digital data interface 415 may be coupled, e.g., to a digital data interface of the signal generation device. Internally, the controller 414 may control the signal analyzer 404 based on digital data exchanged with the signal generation device. The controller 414 may, e.g., control the signal generation device to start or stop generating the test signal 402, and may control the signal analyzer 404 to determine the bit error rate 405, accordingly. The measurement application device, e.g., the controller 414, may also receive information regarding the test signal 402 from the signal generation device via the digital data interface 415. In further embodiments, the measurement application device, especially the controller 414, may communicate with the device under test, for example, to control the device under test to enter a required operating state that may be required for performing a specific test or measurement.

Figure 5 shows a block diagram of an embodiment of a measurement application system 520. The measurement application system 520 comprises a signal generation device 521 and a measurement application device 500. The signal generation device 521 outputs a test signal 502 to a device under test 522. The device under test 522 processes the test signal 502 and outputs a respective output signal 503.

Both, the test signal 502, and the output signal 503 are provided to the measurement application device 500. The measurement application device 500 may comprise a measurement application device according to any one of the embodiments disclosed herein.

In embodiments, the measurement application device 500 and the signal generation device 521 may be integrated into a single device. In other embodiments, a digital communication path may be provided between the signal generation device 521 and the measurement application device 500.

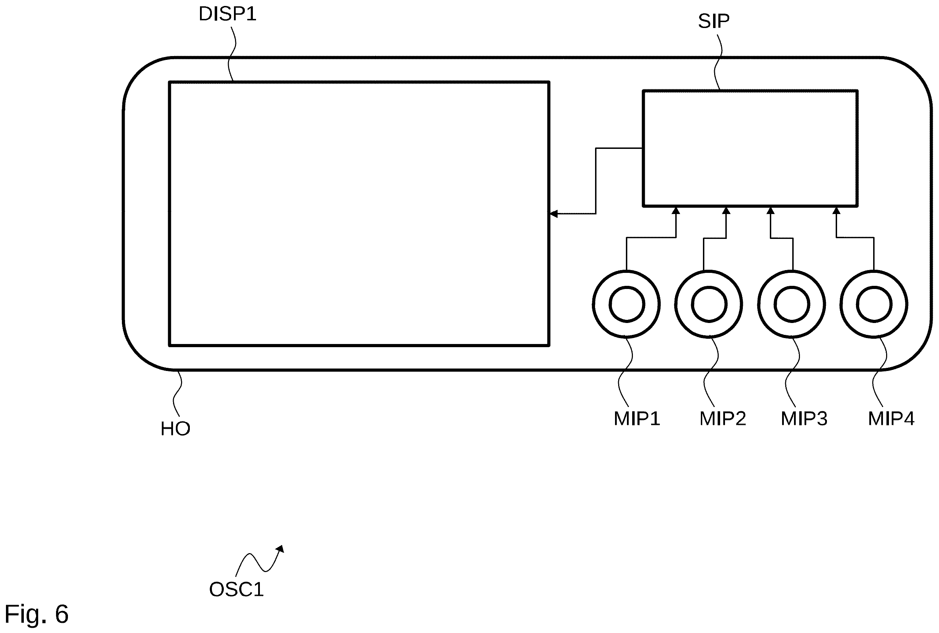

Figure 6 shows a block diagram of an oscilloscope OSC1 that may be used with or as an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

Although not explicitly shown, it is understood, that the oscilloscope OSC1 may also comprise signal outputs. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In the oscilloscope OSC1 the signal processor SIP or an additional processing element may at least in part perform the function of the signal analyzer or any other signal processing element of the measurement application device according to the present disclosure, or may implement the method according to the present disclosure. Of course, a communication interface may be provided in the oscilloscope OSC1 for communication with other measurement devices.

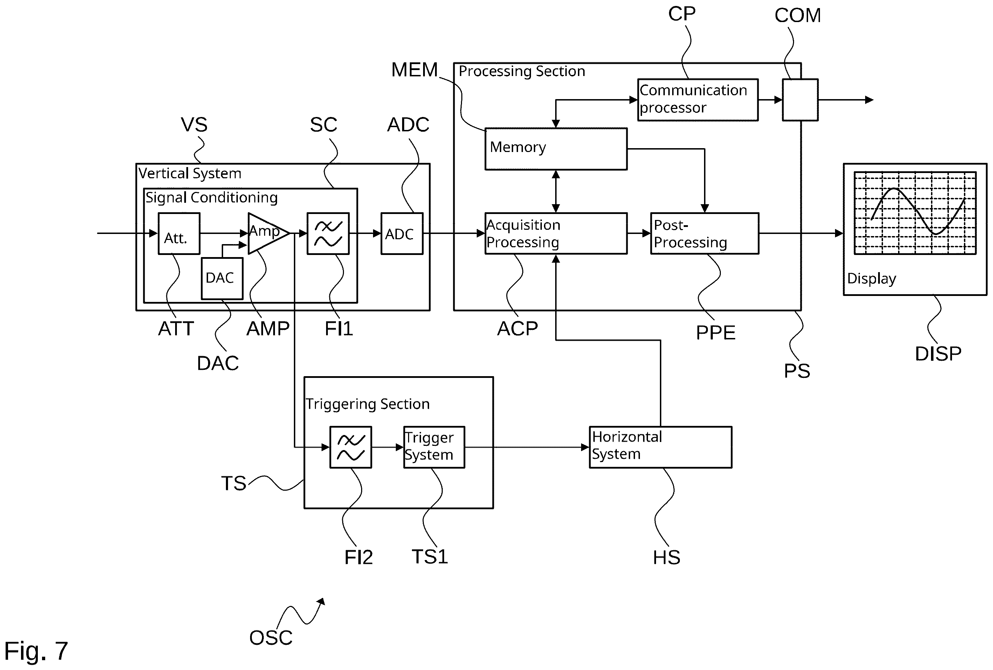

Figure 7 shows a block diagram of an oscilloscope OSC that may be an implementation of a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS and the display DISP. It is understood, that the partitioning into five general sections is a logical partitioning and does not limit the placement and implementation of any of the elements of the oscilloscope OSC in any way.

The vertical system VS mainly serves for offsetting, attenuating and amplifying a signal to be acquired. The signal may for example be modified to fit in the available space on the display DISP or to comprise a vertical size as configured by a user.

To this end, the vertical system VS comprises a signal conditioning section SC with an attenuator ATT and a digital-to-analog-converter DAC that are coupled to an amplifier AMP. The amplifier AMP is coupled to a filter FI1, which in the shown example is provided as a low pass filter. The vertical system VS also comprises an analog-to-digital converter ADC that receives the output from the filter FI1 and converts the received analog signal into a digital signal.

The attenuator ATT and the amplifier AMP serve to scale the amplitude of the signal to be acquired to match the operation range of the analog-to-digital converter ADC. The digital-to-analog-converter DAC serves to modify the DC component of the input signal to be acquired to match the operation range of the analog-to-digital converter ADC. The filter FI1 serves to filter out unwanted high frequency components of the signal to be acquired.

The triggering section TS operates on the signal as provided by the amplifier AMP. The triggering section TS comprises a filter FI2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be provided for the analog-to-digital converter ADC and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the amplifier AMP but will operate on the digital signal as provided by the analog-to-digital converter ADC.

A digital triggering section may comprise a processing element, like a processor, a DSP, a CPLD, an ASIC or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC and the output of the horizontal system HS as well as to a memory MEM and a post processing element PPE.

The acquisition processing element ACP manages the acquisition of digital data from the analog-to-digital converter ADC and the storage of the data in the memory MEM. The acquisition processing element ACP may for example comprise a processing element with a digital interface to the analog-to-digital converter ADC and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infra-red communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

In the oscilloscope OSC, any one of the processing elements in the processing section PS or an additional processing element may at least in part perform the function of the signal analyzer or any other signal processing element of the measurement application device according to the present disclosure, or may implement the method according to the present disclosure.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

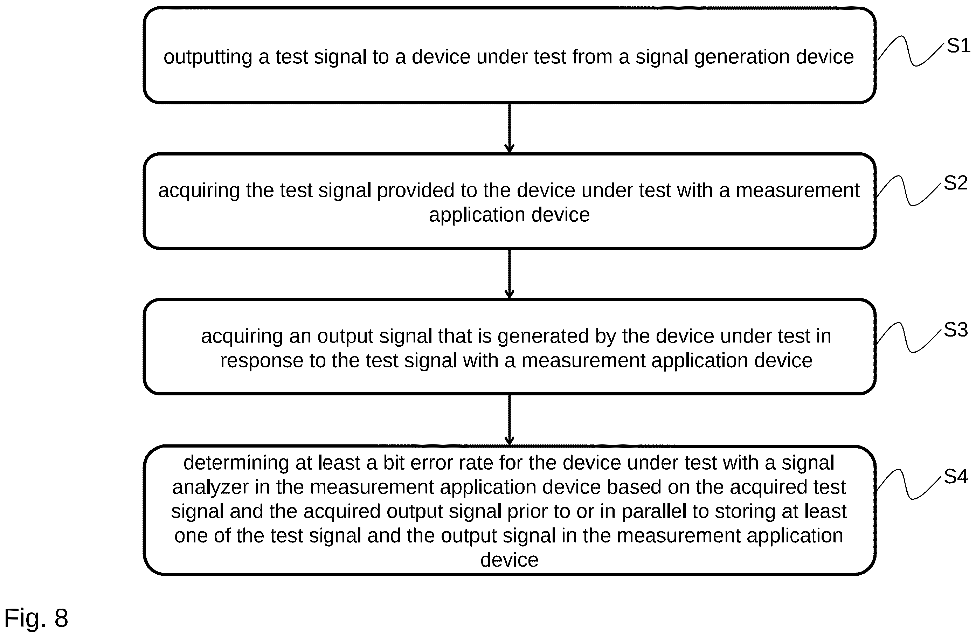

Figure 8 shows a flow diagram of a method for analyzing a device under test.

The method comprises outputting S1 a test signal to a device under test from a signal generation device, acquiring S2 the test signal provided to the device under test with a measurement application device, acquiring S3 an output signal that is generated by the device under test in response to the test signal with a measurement application device, and determining S4 at least a bit error rate for the device under test with a signal analyzer in the measurement application device based on the acquired test signal and the acquired output signal prior to or in parallel to storing at least one of the test signal and the output signal in the measurement application device.

The method may further comprise converting the test signal into a digital test signal and the output signal into a digital output signal each with an analog-to-digital converter in the measurement application device, storing the digital test signal and the digital output signal in an acquisition memory of the measurement application device, and performing the determination of at least the bit error rate based on the digital test signal and the digital output signal prior to or in parallel to storing the digital test signal and the digital output signal.

In embodiments, the method may further comprise decoding the received output signal, and synchronizing the signal analyzer on the output signal based on a known signal type of the output signal.

The method may also comprise generating a predefined PN-sequence after synchronization of the signal analyzer with the output signal, and determining the bit error rate based on the output signal and the generated PN-sequence.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### LIST OF REFERENCE SIGNS

- 100, 200, 300, 400, 500: measurement application device
- 101-1, 101-2, 201-1, 201-2, 301-1, 301-2: measurement input
- 401-1, 401-2: measurement input
- 102, 202, 302, 402, 502: test signal
- 103, 203, 303, 403, 503: output signal
- 104, 204, 304, 404: signal analyzer
- 105, 205, 305, 405: bit error rate

- 208-1, 208-2, 308-1, 308-2: analog-to-digital converter
- 209, 309: acquisition memory
- 210, 310: signal acquisition path

- 312: signal decoder
- 313: sequence generator

- 414: controller
- 415: digital data interface
- 416: information

- 520: measurement application system
- 521: signal generation device
- 522: DUT

- OSC1: oscilloscope
- HO: housing
- MIP1, MIP2, MIP3, MIP4: measurement input
- SIP: signal processing
- DISP1: display

- OSC: oscilloscope
- VS: vertical system
- SC: signal conditioning
- ATT: attenuator
- DAC: digital-to-analog converter
- AMP: amplifier
- FI1: filter
- ADC: analog-to-digital converter

- TS: triggering section
- AMP2: amplifier
- FI2: filter
- TS1: trigger system

- HS: horizontal system

- PS: processing section
- ACP: acquisition processing element
- MEM: memory
- PPE: post processing element

- DISP: display

- S1 - S4: method steps

### Further Embodiments

1. A measurement application device for analyzing a device under test, the measurement application device comprising:
   at least two measurement inputs, wherein one of the measurement inputs is configured to acquire a test signal provided to the device under test by a signal generation device, and one of the measurement inputs is configured to acquire an output signal that is generated by the device under test in response to the test signal; and
   a signal analyzer that is coupled to the at least two measurement inputs and that is configured to determine at least a bit error rate for the device under test based on the test signal and the output signal prior to or in parallel to storing at least one of the test signal and the output signal in the measurement application device.
2. The measurement application device according to embodiment 1, further comprising:
   an analog-to-digital converter for each one of the measurement inputs that is coupled to the respective measurement input;
   an acquisition memory; and
   a signal acquisition path arranged between the analog-to-digital converters, and the acquisition memory;
   wherein the signal analyzer is arranged in the signal acquisition path, and wherein the signal analyzer is coupled to the analog-to-digital converters.
3. The measurement application device according to embodiment 1, wherein the signal analyzer comprises a signal decoder that is configured to decode the received output signal and synchronize the signal analyzer on the output signal based on a known signal type of the output signal.
4. The measurement application device according to embodiment 3, wherein the signal analyzer further comprises a sequence generator that is configured to generate a predefined PN-sequence after synchronization of the signal analyzer with the output signal, and wherein the bit error rate is determined based on the output signal and the generated PN-sequence.
5. The measurement application device according to embodiment 1, wherein the signal analyzer is further configured to identify at least a single erroneous bit transition of the device under test based on the test signal and the output signal, and output a respective user information.
6. The measurement application device according to embodiment 1, wherein the signal analyzer is further configured to output at least one of:
   a determined overall bit error rate;
   an instantaneous bit error rate;
   a bit error rate for a specific time frame; and
   an erroneous bit transition of at least one of the test signal and the output signal.
7. The measurement application device according to embodiment 1, further comprising a digital data interface that is coupled to a digital data interface of the signal generation device;
   wherein the measurement application device is configured to receive information regarding the test signal from the signal generation device via the digital data interface.
8. The measurement application device according to embodiment 7, wherein the measurement input that is configured to acquire the test signal comprises the digital data interface.
9. The measurement application device according to embodiment 1, wherein the measurement application device is further configured to communicate with the device under test.
10. A measurement application device for analyzing a device under test, the measurement application device comprising:
   at least one measurement input, wherein the at least one measurement input is configured to acquire an output signal that is generated by the device under test in response to a test signal that is provided to the device under test; and
   a signal analyzer that is coupled to the at least one measurement input;
   wherein the signal analyzer comprises a signal decoder that is configured to decode the received output signal and synchronize the signal analyzer on the output signal based on a known signal type of the output signal; and
   wherein the signal analyzer further comprises a sequence generator that is configured to generate a predefined PN-sequence after synchronization of the signal analyzer with the output signal; and
   wherein the signal analyzer is configured to determine at least a bit error rate for the device under test based on the output signal and the generated PN-sequence.
11. A measurement application system for analyzing a device under test, the measurement application system comprising:
   a signal generation device configured to output a test signal to a device under test; and
   a measurement application device comprising at least two measurement inputs, wherein one of the measurement inputs is configured to acquire the test signal provided to the device under test, and one of the measurement inputs is configured to acquire an output signal that is generated by the device under test in response to the test signal;
   wherein the measurement application device further comprises a signal analyzer that is coupled to the at least two measurement inputs and that is configured to determine at least a bit error rate for the device under test based on the test signal and the output signal prior to or in parallel to storing at least one of the test signal and the output signal in the measurement application device.
12. The measurement application system according to embodiment 11, comprising:
   a first signal path configured to transport the test signal from the signal generation device to the device under test, a second signal path configured to transport the output signal from the device under test to the measurement application device, and a third signal path configured to transport the test signal from the signal generation device to the measurement application device; or
   a first signal path configured to transport the test signal from the signal generation device to the device under test and the measurement application device, and a second signal path configured to transport the output signal from the device under test to the measurement application device.
13. The measurement application system according to embodiment 11, wherein the signal generation device further comprises a digital data interface; and
   wherein the measurement application device further comprises a digital data interface that is coupled to the digital data interface of the signal generation device; and
   wherein the signal generation device is configured to output information regarding the test signal to the measurement application device via the digital data interface.
14. The measurement application system according to embodiment 13, wherein the measurement input of the measurement application device that is configured to acquire the test signal comprises the digital data interface.
15. The measurement application system according to embodiment 11, wherein at least one of the signal generation device and the measurement application device is further configured to communicate with the device under test.
16. The measurement application system according to embodiment 11, wherein the signal generation device is further configured to generate the test signal with predetermined impairments; and
   wherein the impairments comprise at least one of:
   jitter;
   noise; and
   amplitude variations.
17. The measurement application system according to embodiment 11, wherein the measurement application device further comprises:
   an analog-to-digital converter for each one of the measurement inputs that is coupled to the respective measurement input;
   an acquisition memory; and
   a signal acquisition path arranged between the analog-to-digital converters, and the acquisition memory;
   wherein the signal analyzer is arranged in the signal acquisition path, and wherein the signal analyzer is coupled to the analog-to-digital converters.
18. The measurement application system according to embodiment 11, wherein the signal analyzer comprises a signal decoder that is configured to decode the received output signal and synchronize the signal analyzer on the output signal based on a known signal type of the output signal.
19. The measurement application system according to embodiment 18, wherein the signal analyzer further comprises a sequence generator that is configured to generate a predefined PN-sequence after synchronization of the signal analyzer with the output signal, and wherein the bit error rate is determined based on the output signal and the generated PN-sequence.
20. A measurement method for analyzing a device under test, the method comprising:
   outputting a test signal to a device under test from a signal generation device;
   acquiring the test signal provided to the device under test with a measurement application device;
   acquiring an output signal that is generated by the device under test in response to the test signal with a measurement application device; and
   determining at least a bit error rate for the device under test with a signal analyzer in the measurement application device based on the acquired test signal and the acquired output signal prior to or in parallel to storing at least one of the test signal and the output signal in the measurement application device.
21. The measurement method according to embodiment 20, further comprising:
   converting the test signal into a digital test signal and the output signal into a digital output signal each with an analog-to-digital converter in the measurement application device;
   storing the digital test signal and the digital output signal in an acquisition memory of the measurement application device; and
   performing the determination of at least the bit error rate based on the digital test signal and the digital output signal prior to or in parallel to storing the digital test signal and the digital output signal.
22. The measurement method according to embodiment 20, further comprising:
   decoding the received output signal;
   synchronizing the signal analyzer on the output signal based on a known signal type of the output signal.
23. The measurement method according to embodiment 22, further comprising:
   generating a predefined PN-sequence after synchronization of the signal analyzer with the output signal; and
   determining the bit error rate based on the output signal and the generated PN-sequence.

## Claims

1. A measurement application device for analyzing a device under test, the measurement application device comprising:
at least two measurement inputs, wherein one of the measurement inputs is configured to acquire a test signal provided to the device under test by a signal generation device, and one of the measurement inputs is configured to acquire an output signal that is generated by the device under test in response to the test signal; and
a signal analyzer that is coupled to the at least two measurement inputs and that is configured to determine at least a bit error rate for the device under test based on the test signal and the output signal prior to or in parallel to storing at least one of the test signal and the output signal in the measurement application device.

2. The measurement application device according to claim 1, further comprising:
an analog-to-digital converter for each one of the measurement inputs that is coupled to the respective measurement input;
an acquisition memory; and
a signal acquisition path arranged between the analog-to-digital converters, and the acquisition memory;
wherein the signal analyzer is arranged in the signal acquisition path, and wherein the signal analyzer is coupled to the analog-to-digital converters.

3. The measurement application device according to claim 1, wherein the signal analyzer comprises a signal decoder that is configured to decode the received output signal and synchronize the signal analyzer on the output signal based on a known signal type of the output signal;
especially wherein the signal analyzer further comprises a sequence generator that is configured to generate a predefined PN-sequence after synchronization of the signal analyzer with the output signal, and wherein the bit error rate is determined based on the output signal and the generated PN-sequence.

4. The measurement application device according to claim 1, wherein the signal analyzer is further configured to identify at least a single erroneous bit transition of the device under test based on the test signal and the output signal, and output a respective user information; or .
wherein the signal analyzer is further configured to output at least one of a determined overall bit error rate, an instantaneous bit error rate, a bit error rate for a specific time frame, and an erroneous bit transition of at least one of the test signal and the output signal.

5. The measurement application device according to claim 1, further comprising a digital data interface that is coupled to a digital data interface of the signal generation device, wherein the measurement application device is configured to receive information regarding the test signal from the signal generation device via the digital data interface;
especially wherein the measurement input that is configured to acquire the test signal comprises the digital data interface.

6. The measurement application device according to claim 1, wherein the measurement application device is further configured to communicate with the device under test.

7. A measurement application device for analyzing a device under test, the measurement application device comprising:
at least one measurement input, wherein the at least one measurement input is configured to acquire an output signal that is generated by the device under test in response to a test signal that is provided to the device under test; and
a signal analyzer that is coupled to the at least one measurement input;
wherein the signal analyzer comprises a signal decoder that is configured to decode the received output signal and synchronize the signal analyzer on the output signal based on a known signal type of the output signal; and
wherein the signal analyzer further comprises a sequence generator that is configured to generate a predefined PN-sequence after synchronization of the signal analyzer with the output signal; and
wherein the signal analyzer is configured to determine at least a bit error rate for the device under test based on the output signal and the generated PN-sequence.

8. A measurement application system for analyzing a device under test, the measurement application system comprising:
a signal generation device configured to output a test signal to a device under test; and
a measurement application device according to any one of the preceding claims.

9. The measurement application system according to claim 7, comprising:
a first signal path configured to transport the test signal from the signal generation device to the device under test, a second signal path configured to transport the output signal from the device under test to the measurement application device, and a third signal path configured to transport the test signal from the signal generation device to the measurement application device; or
a first signal path configured to transport the test signal from the signal generation device to the device under test and the measurement application device, and a second signal path configured to transport the output signal from the device under test to the measurement application device.

10. The measurement application system according to claim 7, wherein the signal generation device further comprises a digital data interface; and
wherein the measurement application device further comprises a digital data interface that is coupled to the digital data interface of the signal generation device; and
wherein the signal generation device is configured to output information regarding the test signal to the measurement application device via the digital data interface.

11. The measurement application system according to claim 7, wherein at least one of the signal generation device and the measurement application device is further configured to communicate with the device under test; or
wherein the signal generation device is further configured to generate the test signal with predetermined impairments, and wherein the impairments comprise at least one of jitter, noise, and amplitude variations; or
wherein the measurement application device further comprises an analog-to-digital converter for each one of the measurement inputs that is coupled to the respective measurement input, an acquisition memory, and a signal acquisition path arranged between the analog-to-digital converters, and the acquisition memory, wherein the signal analyzer is arranged in the signal acquisition path, and wherein the signal analyzer is coupled to the analog-to-digital converters.

12. The measurement application system according to claim 7, wherein the signal analyzer comprises a signal decoder that is configured to decode the received output signal and synchronize the signal analyzer on the output signal based on a known signal type of the output signal;
especially wherein the signal analyzer further comprises a sequence generator that is configured to generate a predefined PN-sequence after synchronization of the signal analyzer with the output signal, and wherein the bit error rate is determined based on the output signal and the generated PN-sequence.

13. A measurement method for analyzing a device under test, the method comprising:
outputting a test signal to a device under test from a signal generation device;
acquiring the test signal provided to the device under test with a measurement application device;
acquiring an output signal that is generated by the device under test in response to the test signal with a measurement application device; and
determining at least a bit error rate for the device under test with a signal analyzer in the measurement application device based on the acquired test signal and the acquired output signal prior to or in parallel to storing at least one of the test signal and the output signal in the measurement application device.

14. The measurement method according to claim 13, further comprising:
converting the test signal into a digital test signal and the output signal into a digital output signal each with an analog-to-digital converter in the measurement application device;
storing the digital test signal and the digital output signal in an acquisition memory of the measurement application device; and
performing the determination of at least the bit error rate based on the digital test signal and the digital output signal prior to or in parallel to storing the digital test signal and the digital output signal.

15. The measurement method according to claim 13, further comprising:
decoding the received output signal;
synchronizing the signal analyzer on the output signal based on a known signal type of the output signal;
especially further comprising:
generating a predefined PN-sequence after synchronization of the signal analyzer with the output signal; and
determining the bit error rate based on the output signal and the generated PN-sequence.
